Europäisches Patentamt

(19) European Patent Office

Office européen des brevets

(11) Publication number: **0 042 066**
**B1**

## (12) EUROPEAN PATENT SPECIFICATION

(45) Date of publication of patent specification: **21.03.84**

(21) Application number: **81103734.0**

(22) Date of filing: **15.05.81**

(51) Int. Cl.³: **H 01 L 29/205, H 01 L 29/40**

(54) Intermetallic semiconductor devices.

(30) Priority: **12.06.80 US 158664**

(43) Date of publication of application:
**23.12.81 Bulletin 81/51**

(45) Publication of the grant of the patent:
**21.03.84 Bulletin 84/12**

(84) Designated Contracting States:
**DE FR GB IT**

(56) References cited:
**US - A - 4 075 651**
**US - A - 4 117 504**

(73) Proprietor: **International Business Machines Corporation**
**Old Orchard Road**
**Armonk, N.Y. 10504 (US)**

(72) Inventor: **Woodall, Jerry McPherson**
**336 Cherry Street**
**Bedford Hills New York 10507 (US)**

(74) Representative: **Hobbs, Francis John**
**IBM United Kingdom Patent Operations Hursley Park**
**Winchester, Hants, SO21 2JN (GB)**

Courier Press, Leamington Spa, England.

Intermetallic semiconductor devices

This invention relates to intermetallic semiconductor devices.

A simple metal contact to a body of intermetallic semiconductor material exhibits a barrier to carrier flow which introduces resistance. Various ways of reducing the barrier to current flow at the surface of an intermetallic semiconductor have previously been proposed. One approach, exemplified by U.S. Patent No. 4,188,710 has been to reduce the barrier by the use of heavy doping at the surface of the device using materials such as germanium. Another approach is illustrated in U.S. Patent No. 3,984,261 wherein a substantially homogeneous layer of indium gallium arsenide is placed on a gallium arsenide semiconductor device. This structure, however, introduces another barrier which while smaller than the barrier at the surface still inhibits device performance.

The invention aims at providing a contact to intermetallic semiconductor material which substantially avoids any barrier to current flow.

A semiconductor device according to the invention, comprises a body of intermetallic semiconductor material provided with a contact, the contact comprising an external metallic layer and an intermediate region of semiconductor material atomically compatible with the body disposed between the metallic layer and the body, the device being characterised by the intermediate region having a graded composition such that the lattice and electron affinity of the intermediate region substantially match the lattice and electron affinity of the intermetallic semiconductor material at the interface between the intermediate region and the body and that there exists an ergy gap of less than 0.5 electron volts at the interface between the intermediate region and the external metallic layer. A semiconductor device according to the first part of claim 1 is known from US—A—3 984 261.

The invention will now be explained by way of example, with reference to the accompanying drawings, in which:—

Fig. 1 is an energy level diagram illustrating the conditions present in the low resistance ohmic contact of the invention;

Fig. 2 is a current-against-voltage graph illustrating the ohmic performance of the contact of the invention;

Fig. 3 is an energy level diagram illustrating the barrier to carrier flow present with intermetallic semiconductor-metal contacts;

Fig. 4 is a current-against-voltage graph indicating the rectifying performance of the contact of Fig. 3;

Fig. 5 is an energy level diagram illustrating the effect of high doping at the interface of an intermetallic semiconductor metal contact;

Fig. 6 is a voltage-against-current graph indi-

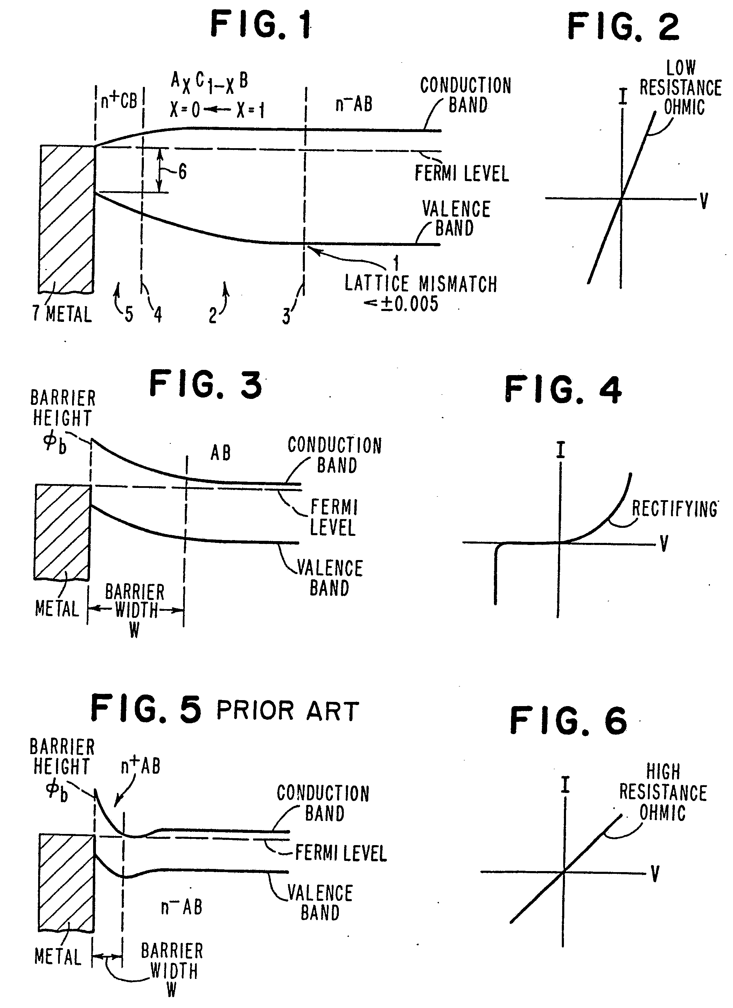

cating ohmic but high resistance performance of the contact of Fig. 5;

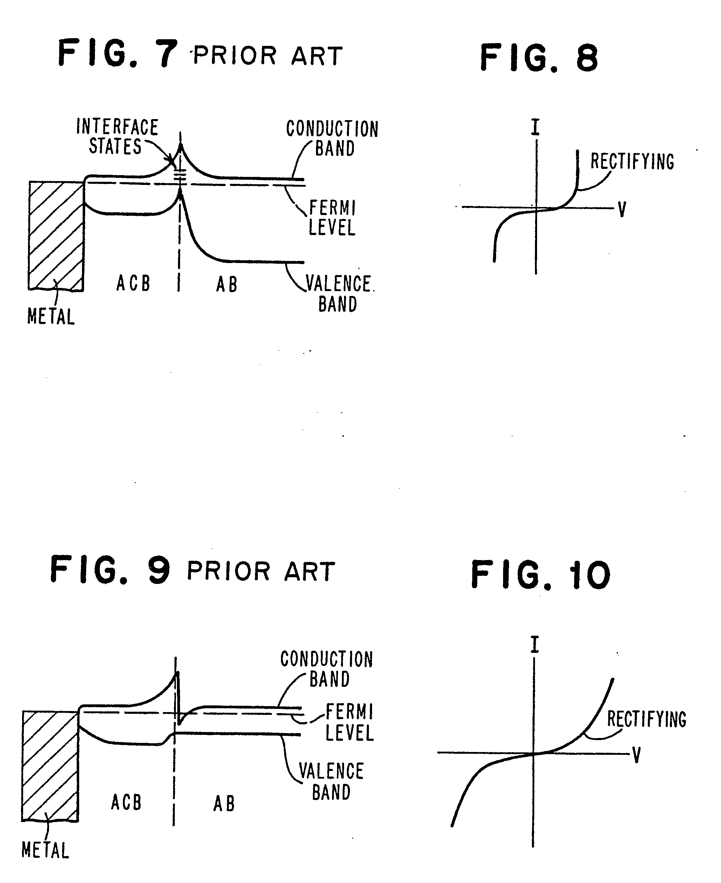

Fig. 7 is an energy level diagram illustrating a barrier present within an intermetallic device when the lattice constants of a semiconductor positioned between a metal contact and the intermetallic semiconductor are mismatched;

Fig. 8 is a current-against-voltage graph indicating rectifying performance of the contact of Fig. 7;

Fig. 9 is an energy level diagram illustrating a barrier present within an intermetallic device having matched lattice constants and different electron affinities of a semiconductor positioned between a metal contact and the intermetallic semiconductor; and

Fig. 10 is a current-against-voltage graph of the contact of Fig. 9 indicating rectifying performance.

A low resistance ohmic contact to an intermetallic semiconductor can be provided by introducing between a metal external contact and the semiconductor an atomically compatible barrier-free semiconductor region with a graded band gap that decreases from the band gap of the intermetallic semiconductor to less than 0.5 electron volts at the interface with the metal external contact. An atomically compatible semiconductor will have an absolute fractional difference in lattice constants at the interface with the intermetallic semiconductor that is either no more than 0.005, or less than the amount necessary to cause misfit dislocation to form. The semiconductor will be atomically compatible with the intermetallic semiconductor if it can be doped to at least a level of $10^{19}/cm^3$ and there is an electron affinity different between the intermetallic semiconductor and the semiconductor of the intermediate region at its interface with the intermetallic semiconductor that is not greater than 0.04 electron volts.

The ohmic contact structure comprises an external metal electrode separated from the body of an intermetallic semiconductor by an intermediate semiconductor region that serves to prevent barrier formation. In Fig. 1 the intermetallic semiconductor is designated 1 which may, for example, be a binary semiconductor designated AB, for example, the material gallium arsenide. The body 1 is shown as having an n-conductivity type. For illustration purposes the energy diagrams in the description will be drawn with n- as an example of one conductivity type, as is well known to those skilled in the art. The transition to the opposite conductivity type may readily be made.

An intermediate semiconductor region 2 is provided that, in essence, avoids a barrier at the surface where an external metal electrode is placed yet does not introduce an interface barrier where it joins the body 1.

In accordance with the invention this is accomplished by providing a close lattice match and small electron affinity difference with the body 1, a small energy gap at the surface with the metal and a graded band gap in between. A graded region of a semiconductor is provided labelled 2. Where the body 1 is a binary semiconductor such as gallium arsenide, the semiconductor may be a ternary semiconductor such as GaInAs having two ingredients, A and B, in common with the binary semiconductor and may have the third ingredient C graded with respect to the first ingredient A such that the ingredient C is substantially absent, or in other words the material is GaAs, at the interface 3 with the body 1 thereby satisfying a barrier forming lattice mismatch requirement and the ingredient A is substantially absent, or in other words the material is InAs, at a line labelled 4.

In other words, on the other side of the line 4, in essence, the intermediate semiconductor will have become another binary semiconductor CB in a region labelled 5 and this semiconductor is such that the energy gap width 6 at an interface with the metal 7 is less than 0.5 electron volts and that it may be doped to at least $10^{19}/\text{cm}^3$.

It is necessary that the absolute fractional lattice mismatch between the atomically compatible semiconductor and the body 1 semiconductor at the interface 3 does not exceed 0.005, or the value which causes misfit dislocation to form. These conditions can be readily satisfied for a binary semiconductor by providing a ternary semiconductor with two elements in common and decreasing the extra element to zero at the interface. As the extra element increases and one of the common elements decreases, the valence band will rise because of the grading of the elements such that the energy gap 6 at the interface with the metal 7 will be the bandgap of the CB semiconductor 5, which for indium arsenide will be a gap 6 in the vicinity of 0.35 electron volts.

Referring to Fig. 2 a voltage-current graph of such a contact is shown. Since all barriers caused by surface carrier traps or states, or by carrier traps at the interface with the region 2 and the body 1 are avoided, the current-voltage characteristic will be a low resistance slope straight line labelled low resistance ohmic. The contact provides resistance values much less than $10^{-6}$ ohm cm.

In intermetallic semiconductors, that is, semiconductors wherein the crystal lattice is made up of periodically arranged atoms of more than one element such as the material gallium arsenide (GaAs), the surface is such that a barrier to current flow is present when a metal external electrode is applied. The presence of the barrier introduces resistance which can interfere with device performance in small signal devices such as Field Effect Transistors or in larger signal devices such as Laser devices.

An ideal ohmic contact may be considered to be one in which the resistance is as shown in Equation 1.

Equation 1: $\rho_c = \dfrac{\partial J^{-1}}{\partial V}$ ohm cm²

where
J=current density through contact at $V \approx 0$.

In order for the rate of change of current and voltage to remain constant, it will be necessary to avoid all non-linear barriers.

The first such non-linear barrier is of the Schottky type wherein a metal contact is placed on the surface of the semiconductor. Under these conditions, a barrier occurs due to a difference of work functions and electron affinities between the metal and the semiconductor.

Referring to Fig. 3 an energy level diagram is provided illustrating a metal contact and barrier on an intermetallic semiconductor. The barrier height is labelled $\phi_b$ and may be expressed for the ideal Schottky barrier contact in Equation 2.

Equation 2:     $\phi_b = \phi_m - \chi$

where
$\phi_b$=barrier height
$\phi_m$=work function of metal contact —
$\chi$=electron affinity of the semiconductor which in turn is the energy to remove an electron from the bottom of the conduction band to vacuum with no kinetic energy.

Equation 2 will be valid when the density of surface states or carrier traps on the intermetallic semiconductor is small and the metal is inert with respect to the semiconductor. Under these conditions, ohmic contacts will occur when $\phi_m$, the work function of the metal contact is less than or equal to $\chi$ the electron affinity of the semiconductor. In practice, however, this situation is rarely observed, especially for elemental and III—V compound intermetallic semiconductors. For example, in the material gallium arsenide, currently receiving considerable attention in the art, the barrier $\phi_b$ of Fig. 3 is nearly always observed to be 0.7 to 0.8 electron volts regardless of the metal used for the contact and its attendant $\phi_m$. The constancy of the barrier $\phi_b$ (Fig. 3) of the gallium arsenide has been attributed to a large density of surface states on the gallium arsenide which operates to pin the barrier $\phi_b$. The magnitude of the barrier $\phi_b$ has had serious detrimental effects since it introduces resistance.

At the present state of the art an evaporated gold contact on gallium arsenide which has been doped to less than or equal to $10^{18}$ still results in a rectifying contact as shown from the voltage-current graph of Fig. 4.

Efforts have taken place in the art that have improved the barrier situation through the use of alloyed contacts but these have some processing limitations. Referring to Fig. 5 an energy level diagram is shown illustrating an alloyed type of contact similar to the example set forth in ·U.S. Patent No. 4,188,710 wherein an alloyed contact such as gold-germanium has been employed.

Referring to Fig. 5 the barrier height $\phi_b$ is present but very heavy doping of the region immediately adjacent the metal contact for a short distance operates to produce a drop in both the conduction and valence band and to sharply narrow the barrier width labelled w. When the barrier width comes into a range for quantum mechanical tunnelling, the carriers no longer have to surmount the full barrier $\phi_b$ but rather tunnel through and consequently as illustrated in Fig. 6, the contact performance is ohmic. Even so, for the high doping levels of about $10^{19}$ achievable for GaAs, this type of contact still gives rise to contact resistance of $\geq 10^{-6}$ ohm cm$^2$ and the operating characteristic in Fig. 6 is labelled high resistance ohmic.

The processes available in the art to provide the heavily doped, narrow w region conditions for tunnelling required close control. The processing, with the attendant heat, introduces process problems that result in difficulty of reproducible results. The depletion width w is a function of doping and is exponentially related to the reciprocal of the doping density. This is a very sensitive parameter. Tunnelling dimensions for w are of the order of a few ten nm (hundred angstroms) but not only are precise times and temperatures required to form the contact but subsequent process steps may interfere with the contact so that not only does the contact require extraordinary control to produce, but contact-to-contact parameters are seldom uniform and subsequent heat related processing may change the contact parameters.

A second problem occurs with the heavily doped type of contact of Fig. 5 in that the $\phi_b$ does introduce some contact resistance and where $\phi_b$ is greater than 0.5 electron volts, even though the rate of change of current with voltage would indicate a contact that is ohmic in nature, still some contact resistance will be present which may be significant in some signal situations. This is true even where the doping density is in the range of $10^{18}$ or $10^{19}$.

It has been found that the best contact resistance for this type of contact is in the vicinity of about $10^{-6}$ ohm centimeters square. Thus, even though the heavily doped or alloy contact as illustrated in connection with Fig. 5 is an improvement over the situation of Fig. 3, the fact remains that it is necessary to lower $\phi_b$ to less than 0.5 electron volts. Especially for contacts to light doped or n- material where the doping level is less than $10^{17}$ it is necessary to keep $\phi_b$ less than 0.5 electron volts in order to provide full device performance flexibility.

Another approach to the contact resistance problem in the art has been the introduction of a semiconductor layer between the intermetallic semiconductor and the metal contact that operates to somewhat reduce the barrier $\phi_b$. An illustration of this type of approach is shown in U.S. Patent No. 3,984,261 wherein a region of indium gallium arsenide (InGaAs) is applied on gallium arsenide (GaAs). In a structure of this type, however, an improvement at the barrier on the surface is offset as is illustrated in Figs. 7 to 10, by the fact that a different barrier is introduced at the interface with the intermetallic semiconductor.

Referring to Fig. 7 an energy level diagram illustrates the type of contact wherein a lower bandgap semiconductor is inserted between the intermetallic semiconductor and the metal external contact. One barrier situation is caused by carrier traps or interface states at the interface of the two semiconductors.

In accordance with the invention this type of barrier is avoided by specifying a lattice match within an absolute fraction of 0.005.

Fig. 7 illustrates a situation in which the lower bandgap semiconductor lattice spacing is larger than that of the intermetallic semiconductor at the interface between the lower bandgap semiconductor and the intermetallic semiconductor. In this instance interface states are shown which operate as carrier traps and introduce a barrier such that the contact performs, as illustrated in the operating caracteristic of Fig. 8, as a rectifier.

Referring next to Fig. 9 a condition for a second barrier situation is illustrated wherein the electron affinity of the lower bandgap semiconductor is smaller than that of the intermetallic semiconductor. In this type of situation there is no appreciable lattice mismatch and hence there are no appreciable interface states but a barrier to electron flow still occurs and the device operates as illustrated in Fig. 10 as a rectifier.

In both situations, the lower bandgap semiconductor reduces the barrier at the interface with the metal but another barrier is encountered at the interface of the semiconductors.

In accordance with the invention it has been found that the barrier situations of Figs. 9 and 10 can be avoided for practical purposes by requiring that the fractional lattice mismatch not exceed 0.005 and that the conditions of the following Equations 4 and 5 be met.

Equation 4: $\dfrac{\alpha_{ACB}-\alpha_{AB}}{\alpha_{AB}}>\pm0.005$

where

$\alpha_{ACB}$=lattice constant of the lower bandgap or ternary semiconductor; and

$\alpha_{AB}$=lattice constant of the intermetallic or binary semiconductor—

In accordance with the invention an electron affinity match is provided between the lower bandgap semiconductor and the intermetallic semiconductor within 0.04 electron volts as expressed in Equation 5.

Equation 5:    $\chi_{AB} - \chi_{AC} \leq 0.04$ eV

where

$\chi$ is the electron affinity of the semiconductor which in turn is the energy to remove an electron from the bottom of the conduction band to vacuum with no kinetic energy.

In accordance with the invention by using a graded bandgap semiconductor, as illustrated in Fig. 1, lattice mismatches and other dislocations can be minimized.

Referring again to the energy diagram of Fig. 1. In a preferred embodiment an n-type layer 2 of the semiconductor ACB will be epitaxially grown by one of the techniques in the art of chemical vapour deposition (CVD) or molecular beam epitaxy (MBE) on an n-type body 1 AB semiconductor using for the AB semiconductor gallium arsenide and the ACB semiconductor $Ga_x In_{1-x} As$ in which x varies to provide a graded composition from pure gallium arsenide at the interface 3 and hence a perfect lattice and electron affinity match to pure indium arsenide at the interface 4 over a distance of approximately 200 nm (2,000 Å). In such a structure in the region 5 at the interface with the metal, the Fermi level is pinned in the conduction band at the n+ indium arsenide interface at an energy of 0.5 eV above the indium arsenide valence band. The energy gap for indium arsenide is approximately 0.35 electron volts. A gold metal contact 7 is evaporated or electroplated with no heating. The resulting structure in accordance with the invention produces an ohmic contact to n-type indium arsenide where the contact resistance is less than $5 \times 10^{-7}$ ohm cm.

## Claims

1. A semiconductor device comprising a body (1) of intermetallic semiconductor material provided with a contact, the contact comprising an external metallic layer (7) and an intermediate region (2, 5) of semiconductor material atomically compatible with the body disposed between the metallic layer and the body, the device being characterised by the intermediate region having a graded composition such that the lattice and electron affinity of the intermediate region substantially match the lattice and electron affinity of the intermetallic semiconductor material at the interface between the intermediate region and the body and that there exists an energy gap of less than 0.5 electron volts at the interface between the intermediate region and the external metallic layer.

2. A device as claimed in claim 1, in which said intermediate region has at the interface with said body a fractional lattice match within 0.005.

3. A device as claimed in claim 1 or claim 2, in which said intermediate region has an electron affinity difference within 0.04 electron volts at its interface with said body.

4. A device as claimed in any of claims 1 to 3, in which the intermediate region is comprised of a ternary semiconductor material and said intermetallic semiconductor material is a compound of two of the elements in said ternary semiconductor material.

5. A device as claimed in claim 4, in which said intermetallic semiconductor material is gallium arsenide, and said ternary semiconductor material is gallium indium arsenide.

6. A device as claimed in claim 5, in which the composition of said intermediate region is graded from being pure gallium arsenide at the interface with said body to being pure indium arsenide at the interface with the external metallic layer.

## Patentansprüche

1. Halbleitervorrichtung, welche einen mit einem Kontakt versehenen Körper (1) aus intermetallischem Halbleitermaterial umfaßt, wobei der Kontakt eine äußere Metallschicht (7) und einen zwischen der Metallschicht und dem Körper angeordneten Zwischenbereich (2, 5) aus mit dem Körper atomar verträglichem Halbleitermaterial umfaßt, wobei die Vorrichtung dadurch gekennzeichnet ist, daß der Zwischenbereich eine verlaufende Zusammensetzung derart hat, daß das Gitter und und die Elektronenaffinität des Zwischenbereichs im wesentlichen dem Gitter und der Elektronenaffinität des intermetallischen Halbleitermaterials an der Grenzfläche zwischen dem Zwischenbereich und dem Körper gleich sind und daß eine Energielücke von weniger als 0,5 Elektronvolt an der Grenzfläche zwischen dem Zwischenbereich und der äußeren Metallschicht vorhanden ist.

2. Vorrichtung nach Anspruch 1, bei welcher der Zwischenbereich an der Grenzfläche mit dem Körper eine normierte Gitterpassung innerhalb von 0,005 hat.

3. Vorrichtung nach Anspruch 1 oder 2, bei welcher der Zwischenbereich eine Elektronenaffinitätsdifferenz innerhalb 0,04 Elektronvolt an seiner Grenzfläche mit dem Körper hat.

4. Vorrichtung nach irgendeinem der Ansprüche 1 bis 3, bei welcher der Zwischenbereich aus einem ternären Halbleitermaterial aufgebaut ist und das intermetallische Halbleitermaterial eine Verbindung aus zweit der Elemente des ternären Halbleitermaterials ist.

5. Vorrichtung nach Anspruch 4, bei welcher das intermetallische Halbleitermaterial Galliumarsenid und das ternäre Halbleitermaterial Galliumindiumarsenid ist.

6. Vorrichtung nach Anspruch 5, bei welcher die Zusammensetzung des Zwischenbereichs von reinem Galliumarsenid an der Grenzfläche mit dem Körper zu reinem Indiumarsenid an der Grenzfläche mit der äußeren Metallschicht verlaufend ist.

## Revendications

1. Un dispositif semi-conducteur comprenant un corps (1) de matière semi-conductrice intermétallique munie d'un contact, le contact comprenant une couche métallique extérieure (7) et une région intermédiaire (2, 5) de matière semi-conductrice, compatible du point de vue atomique avec le corps, disposée entre la couche métallique et le corps, le dispositif étant caractérisé par le fait que la région intermédiaire possède une composition graduée telle que le réseau et l'affinité électronique de la région intermédiaire concorde sensiblement avec le réseau et l'affinité électronique de la matière semi-conductrice intermétallique à l'interface entre la région intermédiaire et le corps, et en ce qu'il existe une bande d'énergie de moins de 0,5 électron-volt à l'interface entre la région intermédiaire et la chouche métallique extérieure.

2. Un dispositif selon la revendication 1, dans lequel ladite région intermédiaire possède en interface avec ledit corps une concordance fractionnaire de réseau en-deçà de 0,005,

3. Un dispositif selon la revendication 1 ou la revendication 2, dans lequel ladite région intermédiaire présente une différence d'affinité électronique en-deçà de 0,04 électron-volt à son interface avec ledit corps.

4. Un dispositif selon l'une des revendications 1 à 3, dans lequel la région intermédiaire est composée d'une matière semi-conductrice ternaire et ladite matière semi-conductrice intermétallique est un composé de deux des éléments contenus dans ladite matière semi-conductrice ternaire.

5. Un dispositif selon la revendication 4, dans lequel ladite matière semi-conductrice intermétallique est l'arséniure de gallium et ladite matière semi-conductrice ternaire est l'arséniure de gallium-indium.

6. Un dispositif selon la revendication 5, dans lequel la composition de ladite région intermédiaire est graduée entre l'arséniure de gallium pur, à l'interface avec ledit corps, et l'aséniure d'indium pur, à l'interface avec la couche métallique extérieure.

# FIG. 1

$A_X C_{1-X} B$
$X=0 \leftarrow X=1$

n+CB

n−AB

CONDUCTION BAND

FERMI LEVEL

6

VALENCE BAND

1

LATTICE MISMATCH < ±0.005

7 METAL

5  4  2  3

# FIG. 2

I

LOW RESISTANCE OHMIC

V

# FIG. 3

BARRIER HEIGHT $\phi_b$

AB

CONDUCTION BAND

FERMI LEVEL

VALENCE BAND

METAL

BARRIER WIDTH W

# FIG. 4

I

RECTIFYING

V

# FIG. 5 PRIOR ART

BARRIER HEIGHT $\phi_b$

n+AB

CONDUCTION BAND

FERMI LEVEL

VALENCE BAND

n−AB

METAL

BARRIER WIDTH W

# FIG. 6

I

HIGH RESISTANCE OHMIC

V

# FIG. 7 PRIOR ART

INTERFACE STATES
CONDUCTION BAND
FERMI LEVEL
VALENCE BAND
ACB
AB
METAL

# FIG. 8

I
RECTIFYING
V

# FIG. 9 PRIOR ART

CONDUCTION BAND
FERMI LEVEL
VALENCE BAND
ACB
AB
METAL

# FIG. 10

I
RECTIFYING
V